# EUROPEAN PATENT SPECIFICATION

(11) **EP 3 958 267 B1**
(45) Date of publication and mention of the grant of the patent: **09.08.2023**
(21) Application number: 20836578.3
(22) Date of filing: 13.07.2020
(51) Int. Cl.: H04L 45/745, G11C 15/04

(54) **RANGE INFORMATION ENCODING AND MATCHING METHOD, AND COMPUTER STORAGE MEDIUM**
CODIERUNGS- UND ANPASSUNGSVERFAHREN FÜR BEREICHSINFORMATIONEN UND COMPUTERSPEICHERMEDIUM
PROCÉDÉ DE CODAGE ET DE MISE EN CORRESPONDANCE D'INFORMATIONS DE PLAGE, ET SUPPORT DE STOCKAGE INFORMATIQUE

(30) Priority: 11.07.2019 CN 201910622597
(43) Date of publication of application: 23.02.2022
(73) Proprietor: Sanechips Technology Co., Ltd., Shenzhen, 518055 (CN)
(72) Inventor: LIU, Fengsong, Shenzhen, Guangdong 518057 (CN); WANG, Siyu, Shenzhen, Guangdong 518057 (CN)
(74) Representative: WBH Wachenhausen Patentanwälte PartG mbB
(86) International application number: PCT/CN2020/101595
(87) International publication number: WO 2021/004543

(56) References cited:
- CN-A- 101 009 656
- CN-A- 101 222 434
- CN-A- 103 546 378
- US-A1- 2006 262 583
- US-B2- 7 814 268
- KARTHIK LAKSHMINARAYANAN ET AL: "Algorithms for advanced packet classification with ternary CAMs", APPLICATIONS, TECHNOLOGIES, ARCHITECTURES, AND PROTOCOLS FOR COMPUTER COMMUNICATIONS, ACM, 2 PENN PLAZA, SUITE 701 NEW YORK NY 10121-0701 USA, 22 August 2005 (2005-08-22), pages 193-204, XP058144789, DOI: 10.1145/1080091.1080115 ISBN: 978-1-59593-009-5

## Description

### TECHNICAL FIELD

The present disclosure relates to the field of information processing, for example, to range information encoding and matching methods, devices and a computer-readable storage medium.

### BACKGROUND

When a ternary content addressable memory (TCAM) performs packet classification, a range needs to be decomposed and converted into prefixes if a range-type field is required in a storage entry, and the range-to-prefix conversion will lead to a significant increase in the number of entries to be stored. For example, a single 16-bit range can be decomposed into up to 31 prefixes. A typical entry for packet classification usually contains two 16-bit ranges, which can be decomposed into up to 31*31=961 prefixes. The situation described above is the socalled range expansion problem, which, during product application, causes a sharp decrease in the utilization rate of TCAM resources corresponding to some packet classification rule sets.

In existing technologies, a solution to the range expansion problem is to use optimized general range encoding technologies and use additional TCAM resources to encode ranges so as to reduce the cost of range expansion, which is focused on any arbitrary type of rule sets and is not based on the observation of the rule sets.

During actual usage of a rule set, the cost of range expansion is still very high due to the generality of the rule set, and the average expansion degree of two range fields cannot meet product requirements

Document US 2006/262583 A1 discloses a range representation in a content addressable memory using an improved encoding scheme.

### SUMMARY

Embodiments of the present disclosure provide range information encoding and matching methods, devices and a computer-readable storage medium, which can overcome the problem of range expansion of TCAMs in existing technologies to at least a certain extent.

An embodiment of the present disclosure provides a range information encoding method, including: acquiring a new base range, where the new base range is used for decomposing range information of an entry to be stored in a TCAM; performing an expansion operation on the new base range based on a plurality of pre-stored base ranges to obtain an expansion result, where each of the pre-stored base ranges has respective encoded information; and determining, according to the expansion result, encoded information corresponding to the new base range.

An embodiment of the present disclosure provides a computer-readable storage medium storing a computer program which, when executed by a processor, causes the processor to perform the range information encoding method described above.

An embodiment of the present disclosure provides a range information encoding device including: a processor; and a memory storing a computer program which, when executed by the processor, causes the processor to perform the range information encoding method described above.

An embodiment of the present disclosure provides a range information matching method, including: acquiring range field information carried in an obtained packet; matching the range field information with a base range obtained by using the range information encoding method described above to obtain a matching result; and processing the packet according to the matching result.

An embodiment of the present disclosure provides a computer-readable storage medium storing a computer program which, when executed by a processor, causes the processor to perform the range information matching method described above.

An embodiment of the present disclosure provides a range information matching device including: a processor; and a memory storing a computer program which, when executed by the processor, causes the processor to perform the range information matching method described above.

### BRIEF DESCRIPTION OF DRAWINGS

The accompanying drawings are used to provide an understanding of the technical schemes of the present disclosure and constitute a part of the description. The accompanying drawings are used to explain the technical schemes of the present disclosure together with the embodiments of the present disclosure, and do not constitute a restriction on the technical schemes of the present disclosure.
Fig. 1 is a flowchart of a range information encoding method according to an embodiment of the present disclosure;
Fig. 2 is a flowchart of a range encoding method according to an embodiment of the present disclosure;
Fig. 3 is a schematic diagram of a new base range according to an embodiment of the present disclosure;
Fig. 4 is a schematic diagram of an expansion result of a new base range as shown in Fig. 3;
Fig. 5 is another schematic diagram of an expansion result of a new base range as shown in Fig. 3; and
Fig. 6 is a flowchart of a range information matching method according to an embodiment of the present disclosure.

### DETAILED DESCRIPTION

The embodiments of the present disclosure will be described below in combination with the accompanying drawings.

The steps shown in the flowcharts of the drawings may be performed in a computer system, such as with a set of computer-executable instructions. Moreover, although a logical order is shown in the flowcharts, the steps shown or described may be performed, in some cases, in a different order from that shown or described herein.

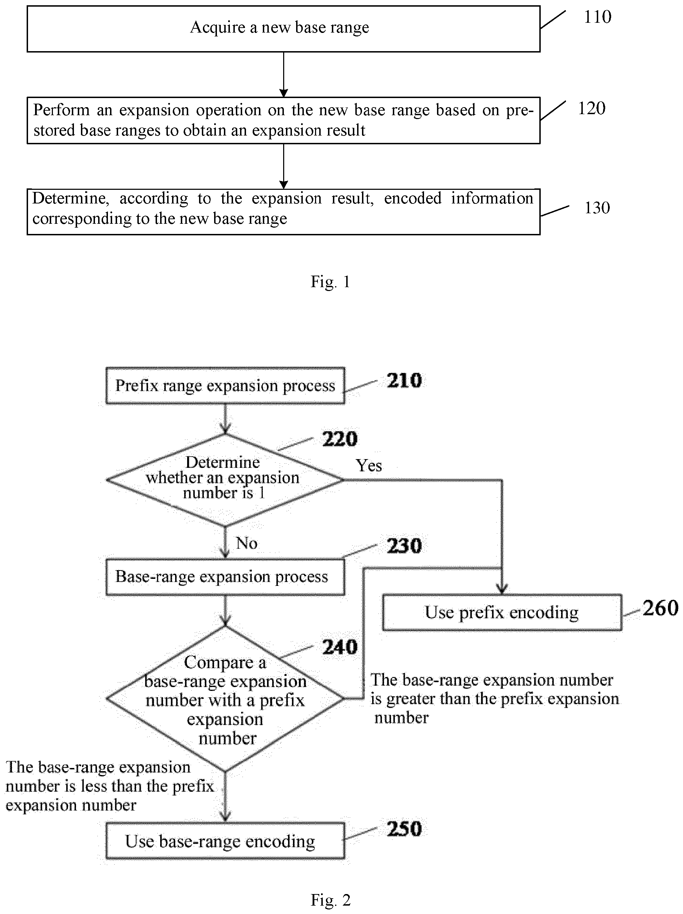

Fig. 1 is a flowchart of a range information encoding method according to an embodiment of the present disclosure. The method shown in Fig. 1 includes the following steps.

At step 110, a new base range is acquired, where the new base range is used for decomposing range information of an entry to be stored in a TCAM.

In an embodiment, a base range is used for decomposing range information of an entry to be stored in a TCAM, and different base ranges may not overlap with each other or may partly overlap with each other.

At step 120, an expansion operation is performed on the new base range based on pre-stored base ranges to obtain an expansion result, where each pre-stored base range has respective encoded information.

In an embodiment, the pre-stored base ranges are obtained in the following approach. When no base range is stored locally and a base range is received, the base range may be converted into a prefix(es), and the base range may be stored with the entry information corresponding to the prefix(es). When the obtained base ranges reach a threshold number of pre-stored base ranges, the newly received base range may be processed by the method according to embodiments of the present disclosure.

In an embodiment, performing an expansion operation on the new base range based on pre-stored base ranges to obtain an expansion result includes: on condition that each pre-stored base range has a respective corresponding field, selecting the field including a maximum number of base ranges as a target field; and expanding the new base range by using the base range in the target field to obtain a plurality of sub-ranges after the expansion.

All the fields that have been assigned with a base range are traversed to find the field with the most expansion entries in these fields as the target field, and then the new base range is expanded by using the base range on the target field.

At step 130, encoded information corresponding to the new base range is determined according to the expansion result.

In an embodiment, compared with the existing technologies in which the range information is decomposed first and then converted into prefixes, the embodiment of the present disclosure expands a new base range by using the pre-stored base ranges, thereby realizing the purpose of denoting the new base range by using the existing base ranges and reducing the storage consumption of the base ranges.

The method provided by the embodiment of the present disclosure includes acquiring a new base range, performing an expansion operation on the new base range based on pre-stored base ranges to obtain an expansion result, and then determining, according to the expansion result, encoded information corresponding to the new base range, thereby realizing the purpose of encoding the new base range by using the existing base ranges, overcoming the range expansion problem of TCAM in existing technologies and improving the resource utilization rate.

The method provided by the present disclosure is described below.

In an embodiment, before performing an expansion operation on the new base range based on pre-stored base ranges to obtain an expansion result, the method also includes: determining a number of entries of the new base range after being subjected to prefix expansion; on condition that the number of entries of the new base range after being subjected to prefix expansion is not 1, performing the expansion operation on the new base range.

By determining whether the number of entries of the new base range after being subjected to prefix expansion is 1 before executing the base-range expansion operation, the number of base-range expansion operations to be executed can be effectively restrained, thus enhancing the processing efficiency.

In an embodiment, expanding the new base range by using the base range in the target field includes: traversing all the base ranges in the target field, and expanding the new base range by using a minimal number of base range, where a coverage of the used base range(s) does not exceed the new base range.

On condition that the target field includes at least two base ranges, the base ranges in the target field can be combined such that the combined coverage does not exceed the new base range. By using the minimum number of base ranges, the number of entries of the new base range can be minimized, thus improving the management efficiency.

In an embodiment, expanding the new base range by using the base range in the target field to obtain a plurality of sub-ranges after the expansion includes: after expanding the new base range by using the base range in the target field, determining whether the used base range covers the new base range entirely; in response to a determination result that the used base range cannot cover the new base range entirely, acquiring an uncovered sub-range in the new base range; and carrying out prefix expansion on the sub-range to obtain an entry corresponding to the sub-range.

By determining the state of coverage of the expansion result and carrying out prefix expansion on the uncovered sub-range, the base-range expansion and the prefix expansion are combined such that the new base range can be covered entirely.

In an embodiment, performing an expansion operation on the new base range based on pre-stored base ranges to obtain an expansion result includes: acquiring a number of entries of the new base range after being subjected to the expansion operation based on the pre-stored base ranges; comparing the number of entries of the new base range after being subjected to the expansion operation with a pre-acquired number of entries of the new base range after being subjected to prefix expansion; on condition that the number of entries of the new base range after being subjected to prefix expansion is less than the number of entries of the new base range after being subjected to the expansion operation, using a prefix/prefixes obtained from the prefix expansion as entry information corresponding to the new base range, or on condition that the number of entries of the new base range after being subjected to prefix expansion is greater than or equal to the number of entries of the new base range after being subjected to the expansion operation, determining entry information of the new base range based on entry information corresponding to multiple components of the expansion result of the new base range.

Fig. 2 is a flowchart of a range encoding method according to an embodiment of the present disclosure. As shown in Fig. 2, the method includes:
step 210: carrying out a prefix range expansion process on a range of a current entry and counting the number of prefixes converted from the range of the current entry, which is denoted as p_range_num;
step 220: determining whether p_range_num is 1, and proceeding to step 260 if p_range_num is 1, or proceeding to step 230 if p_range_num is not 1;
step 230: carrying out a base-range expansion process and counting a base-range expansion number of the current entry, which is denoted as b_range_num;
step 240: comparing p_range_num with b_range_num, and proceeding to step 260 if p_range_num is less than b_range_num, or proceeding to step 250 if p_range_num is greater than or equal to b_range_num;
step 250: storing encoded information of the range into a TCAM memory module using base-range encoding;
step 260: storing encoded information of the range into a TCAM memory module directly through prefix decomposition.

In this way, encoding management of a new base range can be realized.

In an embodiment, the encoded information of the pre-stored base ranges includes encoded information corresponding to field information and encoded information corresponding to range information.

Fields can be identified with the encoded information corresponding to the field information of the base range. The encoded information corresponding to range information may be denoted with 1 bit to simplify the occupation of codings of the base ranges.

The range information encoding method provided by the embodiment of the present disclosure will be described below.

For packet classification rule sets containing ranges, each single base range may be encoded in one bit and an optimized encoding strategy may be provided in combination with a hardware-based parallel comparison function to alleviate the range expansion problem of TCAMs. As a small number of base ranges can be recombined into numerous combinational ranges, the utilization rate of resources can be maximized with limited TCAM resources.

The range information encoding method according to the present disclosure includes the following steps.

An Internet Protocol Version 4 (IPv4) type rule set contains N K-bit range fields, which are respectively denoted as R_FIELD_0, R FIELD_1, ......, and R_FIELD_(N-1). A width of extra M bits is made available to the entry width for range encoding to expand the N range fields that share 32 bits in total. A range encoding process is as follows:
At step 210, as the rule set may be issued dynamically or all at once, base ranges represented by all the M bits may be pre-configured and the base ranges are distinguished in their fields. If no base range is pre-configured, the first M ranges encountered that cannot be directly converted into a prefix representation (i.e., the number of entries of the range after being subjected to prefix expansion is not 1) are used as the base ranges.
At step 220, after allocation of all the M base ranges is completed, each issued rule is expanded according to the following sub-steps.
   a) Firstly, a prefix expansion number is counted. If a rule can be expanded directly, the rule will be stored in the TCAM directly with its prefix expansion result, and the process ends. If a rule cannot be expanded directly, the process proceeds to sub-step b).
   b) All the fields that have been allocated with a base range are traversed to find the field within which the rule has a maximum number of expansion entries. If the maximum number of expansion entries is 1, the rule will be stored in the TCAM directly with its prefix expansion result. If the maximum number of expansion entries is greater than 1, the process proceeds to sub-step c).
   c) The rule mapped to the field is denoted as <range>. The <range> is expanded by using base ranges in the field. All the base ranges in this field are traversed to find a minimum number of base ranges that have the largest coverage without exceeding boundaries of the <range>. The uncovered part(s) is/are expanded through prefix expansion.
   d) The total number of entries of the field expanded in the base-range expansion manner is compared with the number of entries of the field expanded directly in the prefix expansion manner, then the expansion manner providing the smaller number of entries is selected to expand the <range>, and the <range> after being expanded in the selected manner is stored in the TCAM.

The process of expanding the <range> by using the base ranges in the field includes the following steps.

The base-range expansion is carried out by building a tree and traversing all the base ranges so as to find the optimal combination for expansion. If a base range is not within the <range>, the base range is to be skipped. If a base range is within the <range>, the base range is to be used as a root node, and a number of expansion entries is counted after the expansion is completed.

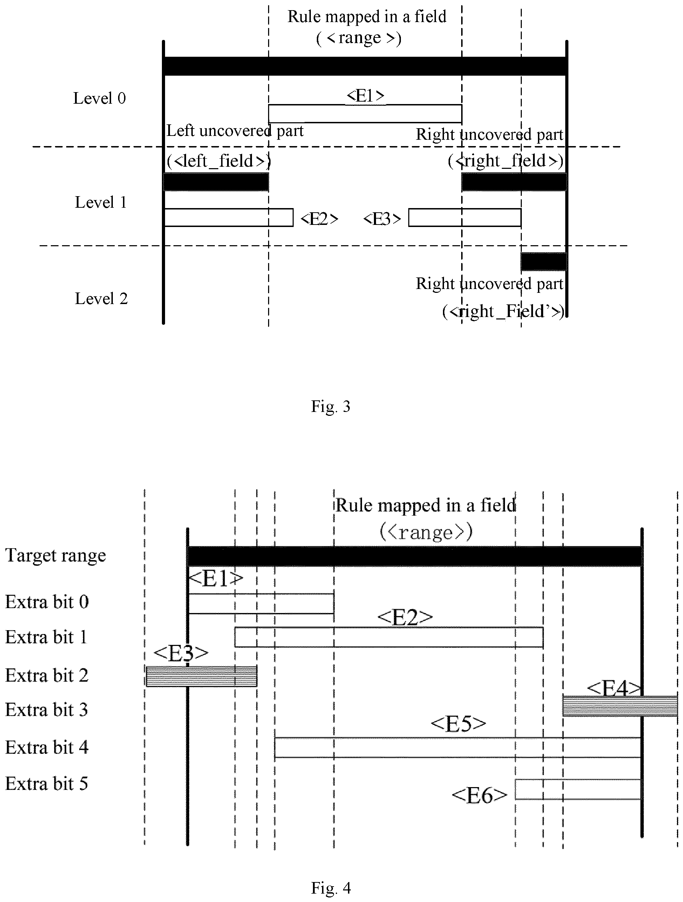

Fig. 3 is a schematic diagram of a new base range according to an embodiment of the present disclosure. As shown in Fig. 3, <E1> is selected as a root node to expand the <range>. The left and right endpoints of the <range> are original_min and original_max, respectively. If the <range> contains <E1>, but original_min is less than the left endpoint of <E1>, it is indicated that there is an uncovered part on the left, and this remaining range is denoted as <left_field>. Similarly, an uncovered part on the right, if any, is denoted as <right_field>.

In the range shown in Fig. 3, a left subnode and a right subnode are created to store expansion numbers of <left_field> and <right_field>, respectively. In this case, <E1> is in the root node, and the expansion number of the root node is 1. Then, the total expansion number of the <range> is 1+num(left)+num(right), where num(left) and num(right) are the range expansion numbers stored in the left and right subnodes, respectively.

Recursive processing is performed for expansion of the left and right remaining ranges to obtain num(left) and num (right), respectively. Taking <left_field> as an example, prefix expansion is attempted first. If a resulting prefix expansion number is 1, the tree building stops. If the resulting prefix expansion number is not 1, a search is conducted for a base range that can include <left_field> entirely and is within the <range>, such as <E2> shown in the figure. If such a base range is found, the tree building also stops. If such a base range cannot be found, such as in the case of <right_field> in the figure, the process proceeds with traversing all the ranges that partially cover <right_field> and are included in the <range>, and continues to attempt expansion (such as <E3> + <right_field'> in the figure) until the expansion is completed or the expansion number with further decomposition is larger than the expansion number by directly using prefixes, and then the tree building stops.

A range information encoding process includes the following steps.

During storage operation of the TCAM, one entry is generated for each <Ei> used. A rule mapped for a range field (the <range>) is expanded through base-range expansion, assuming that the range field is 8 bits wide, 4 extra bits are used for base-range encoding of the field, and <Ei> (i>1) corresponds to the (i-1)th bit.

Fig. 4 is a schematic diagram of an expansion result of a new base range as shown in Fig. 3. As shown in Fig. 4, the expansion scheme finally determined for the <range> is to use <E1>, <E2> and <E5> for expansion, and then 3 entries to be stored in the TCAM are obtained as follows:
Entry 1: ^{∗∗∗∗ ∗∗∗∗} 1^{∗∗∗}; Entry 2: ^{∗∗∗∗ ∗∗∗∗ ∗}1^{∗∗}; Entry 3: **** **** **1*.

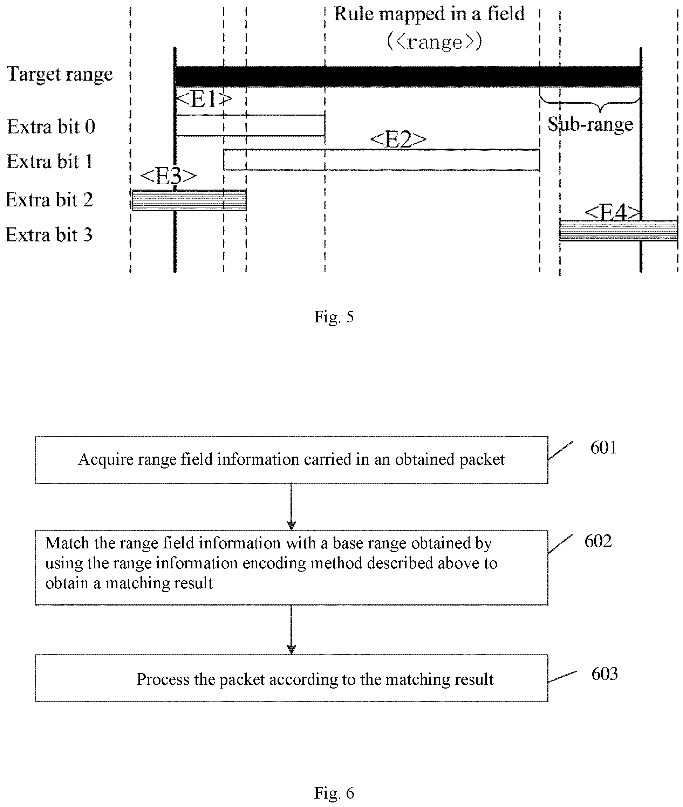

Fig. 5 is another schematic diagram of an expansion result of a new base range as shown in Fig. 3. As shown in Fig. 5, the final scheme for the expansion of the <range> is to use <E1>, <E2> and two additional prefix ranges for expansion, and then 4 entries to be stored in the TCAM are obtained as follows:
Entry 1: **** **** 1***; Entry 2: **** **** *1**; Entry 3: xxxx xxxx ****; Entry 4: xxxx xxxx ^{∗∗∗∗}.

The x-sequence represents a prefix-form ternary bit string, and * represents the "don't care" state of the three states.

In a real-world rule set, the number of different ranges is usually limited. Based on this property of rule sets, the range information encoding method provided by the embodiments of the present disclosure performs targeted range encoding based on prefix expansion, but excels in performance compared to prefix expansion, and the expansion number is optimized to different extents for different rule sets. When preprocessing fails under a high system load, the method of the present disclosure is completely compatible with prefix expansion encoding and rule issuing methods, so that there is a theoretical lower bound. Compared with existing technologies, the present disclosure, by using a small amount of additional TCAM resources, alleviates the problem of low resource utilization rate caused by range expansion and also increases the stability of resource utilization rate as multiple base ranges can be used for encoding at the same time.

An embodiment of the present disclosure provides a computer-readable storage medium storing a computer program which, when executed by a processor, causes the processor to perform any of the methods described in Figs. 1-5 above.

The computer-readable storage medium provided by the embodiment of the present disclosure acquires a new base range, performs an expansion operation on the new base range based on pre-stored base ranges to obtain an expansion result, and then determines, according to the expansion result, encoded information corresponding to the new base range, thereby realizing the purpose of encoding the new base range by using the existing base ranges, overcoming the range expansion problem of TCAM in existing technologies and improving the resource utilization rate.

An embodiment of the present disclosure provides a range information encoding device including: a processor; and a memory storing a computer program which, when executed by the processor, causes the processor to perform the range information encoding method described in Figs. 1-5 above.

Fig. 6 is a flowchart of a range information matching method according to an embodiment of the present disclosure. The method shown in Fig. 6 includes the following steps.

At step 610, range field information carried in an obtained packet is acquired.

At step 620, the range field information is matched with a base range obtained by using the range information encoding method described above to obtain a matching result.

In an embodiment, a range field in an input key is compared against all the N pre-configured base range(s) in parallel. The key calculation method is to compare a range field of a packet against all the base range(s) of a corresponding field. If the range field of the packet falls within a base range, a corresponding bit is coded as 1. If the range field of the packet does not fall within a base range, a corresponding bit is coded as 0. All bits of a key sent to the TCAM for comparison are determined binary values (0 or 1).

At step 630, the packet is processed according to the matching result.

The method provided by the embodiment of the present disclosure includes acquiring range field information carried in an obtained packet, matching the range field information with a base range obtained by using the range information encoding method described above to obtain a matching result, and processing the packet according to the matching result, which matches the range field information by using the coding of the base range and thus improves the search efficiency for the range field information.

An embodiment of the present disclosure provides a computer-readable storage medium storing a computer program which, when executed by a processor, causes the processor to perform the method described in Fig. 6 above.

The computer-readable storage medium provided by the embodiment of the present disclosure acquires range information carried in an obtained packet, matches the range information with a base range obtained by using the range information encoding method described above to obtain a matching result, and processes the packet according to the matching result, which matches the range information by using the coding of the base range and thus improves the search efficiency for the range information.

An embodiment of the present disclosure provides a range information matching device including: a processor; and a memory storing a computer program which, when executed by the processor, causes the processor to perform the range information matching method described in Fig. 6 above.

It can be understood by those having ordinary skills in the art that all or some of the steps of the methods, systems and functional modules/units in the devices disclosed above can be implemented as software, firmware, hardware and any appropriate combinations thereof. In the hardware implementation, the division between functional modules/units mentioned in the above description does not necessarily correspond to the division of physical components; for example, a physical component may have multiple functions, or a function or step may be performed cooperatively by a plurality of physical components. Some or all of the components may be implemented as software executed by a processor, such as a digital signal processor or a microprocessor, or as hardware, or as an integrated circuit, such as an application-specific integrated circuit. Such software can be distributed on computer-readable media, which can include computer-readable storage media (or non-transitory media) and communication media (or transitory media). As well known to those of ordinary skill in the art, the term computer-readable storage medium includes volatile and nonvolatile, removable and non-removable media implemented in any method or technology for storing information, such as computer-readable instructions, data structures, program modules or other data. The computer-readable storage media include, but are not limited to, random access memory (RAM), read-only memory (ROM), electrically erasable programmable read-only memory, EEPROM), flash memory or other memory technologies, portable compact disc read-only memory (CD-ROM), digital video disc (DVD) or other optical disc storage, cassettes, magnetic tapes, magnetic disc storage or other magnetic storage devices, or any other media that can be used to store desired information and can be accessed by computers. Furthermore, it is well known to those of ordinary skill in the art that communication media typically contain computer-readable instructions, data structures, program modules or other data in a modulated data signal such as a carrier wave or other transmission mechanism, and can include any information delivery media.

## Claims

1. A range information encoding method, comprising:
acquiring a new base range, wherein the new base range is used for decomposing range information of an entry to be stored in a ternary content addressable memory, TCAM (110);
**characterised in that** the method is further comprising :
performing an expansion operation on the new base range based on a plurality of pre-stored base ranges to obtain an expansion result, wherein each of the pre-stored base ranges has respective encoded information (120); and
determining, according to the expansion result, encoded information corresponding to the new base range (130).

2. The method of claim 1, before performing an expansion operation on the new base range based on a plurality of pre-stored base ranges to obtain an expansion result, further comprising:
determining a number of entries of the new base range after being subjected to prefix expansion;
wherein performing an expansion operation on the new base range based on a plurality of pre-stored base ranges comprises:
in response to the number of entries of the new base range after being subjected to prefix expansion being not 1, performing the expansion operation on the new base range based on the plurality of pre-stored base ranges.

3. The method of claim 1 or claim 2, wherein performing an expansion operation on the new base range based on a plurality of pre-stored base ranges to obtain an expansion result comprises:
in response to each of the pre-stored base ranges having a respective corresponding field, selecting the field corresponding to one of the plurality of base ranges, which has a maximum number of entries after being subjected to prefix expansion, as a target field; and
expanding the new base range by using at least one of the base ranges in the target field to obtain a plurality of ranges after the expansion.

4. The method of claim 3, wherein expanding the new base range by using the base range in the target field comprises:
traversing all the base ranges in the target field, and expanding the new base range by using a minimal number of base ranges, wherein a coverage of the minimal number of base ranges does not exceed the new base range.

5. The method of claim 3 or claim 4, wherein expanding the new base range by using at least one of the base ranges in the target field to obtain a plurality of ranges after the expansion comprises:
after expanding the new base range by using the at least one base range in the target field, determining whether the at least one used base range covers the new base range entirely;
in response to a determination result that the at least one used base range cannot cover the new base range entirely, acquiring a sub-range, uncovered by the at least one used base range, of the new base range; and
carrying out prefix expansion on the uncovered sub-range to obtain an entry corresponding to the uncovered sub-range.

6. The method of claim 1 or claim 2, wherein performing an expansion operation on the new base range based on a plurality of pre-stored base ranges to obtain an expansion result comprises:
acquiring a number of entries of the new base range after being subjected to the expansion operation based on the plurality of pre-stored base ranges;
comparing the number of entries of the new base range after being subjected to the expansion operation with the acquired number of entries of the new base range after being subjected to prefix expansion;
in response to the number of entries of the new base range after being subjected to prefix expansion being less than the number of entries of the new base range after being subjected to the expansion operation, using prefix information obtained from the prefix expansion as entry information corresponding to the new base range; or in response to the number of entries of the new base range after being subjected to prefix expansion being greater than or equal to the number of entries of the new base range after being subjected to the expansion operation, determining entry information of the new base range based on entry information corresponding to multiple components of the expansion result of the new base range.

7. The method of claim 1, wherein the encoded information of each of the pre-stored base ranges comprises encoded information corresponding to field information and encoded information corresponding to range information.

8. A range information matching method, comprising:
acquiring range field information carried in an obtained packet (601);
matching the range field information with a base range obtained by using the range information encoding method of any one of claims 1 to 7 to obtain a matching result (602); and
processing the packet according to the matching result (603).

9. A computer-readable storage medium storing a computer program which, when executed by a processor, causes the processor to perform the range information encoding method of any one of claims 1 to 7.

10. A range information encoding device, comprising: a processor; and a memory storing a computer program which, when executed by the processor, causes the processor to perform the range information encoding method of any one of claims 1 to 7.

11. A computer-readable storage medium storing a computer program which, when executed by a processor, causes the processor to perform the range information matching method of claim 8.

12. A range information matching device, comprising: a processor; and a memory storing a computer program which, when executed by the processor, causes the processor to perform the range information matching method of claim 8.

## Patentansprüche

1. Codierverfahren für Bereichsinformationen, umfassend:
Erfassen eines neuen Basisbereichs, wobei der neue Basisbereich zum Zerlegen von Bereichsinformationen eines in einem ternären inhaltsadressierbaren Speicher, TCAM (110), zu speichernden Eintrags verwendet wird;
**dadurch gekennzeichnet, dass** das Verfahren ferner umfasst:
Durchführen einer Expansionsoperation an dem neuen Basisbereich basierend auf einer Mehrzahl von vorab gespeicherten Basisbereichen, um ein Expansionsergebnis zu erhalten, wobei jeder der vorab gespeicherten Basisbereiche jeweilige codierte Informationen (120) aufweist; und
Bestimmen, basierend auf dem Expansionsergebnis, von codierten Informationen, die dem neuen Basisbereich (130) entsprechen.

2. Verfahren nach Anspruch 1, das vor dem Durchführen einer Expansionsoperation an dem neuen Basisbereich basierend auf einer Mehrzahl von vorab gespeicherten Basisbereichen, um ein Expansionsergebnis zu erhalten, ferner umfasst:
Bestimmen einer Anzahl von Einträgen des neuen Basisbereichs, nachdem dieser einer Präfixexpansion unterzogen wurde;
wobei das Durchführen einer Expansionsoperation an dem neuen Basisbereich basierend auf einer Mehrzahl von vorab gespeicherten Basisbereichen umfasst:
als Reaktion darauf, dass die Anzahl der Einträge des neuen Basisbereichs, nachdem er einer Präfixexpansion unterzogen wurde, nicht 1 ist, Durchführen der Expansionsoperation an dem neuen Basisbereich basierend auf der Mehrzahl von vorab gespeicherten Basisbereichen.

3. Verfahren nach Anspruch 1 oder Anspruch 2, wobei das Durchführen einer Expansionsoperation an dem neuen Basisbereich basierend auf einer Mehrzahl von vorab gespeicherten Basisbereichen, um ein Expansionsergebnis zu erhalten, umfasst:
als Reaktion darauf, dass jeder der vorab gespeicherten Basisbereiche ein jeweiliges entsprechendes Feld hat, Auswählen des Feldes, das einem der Mehrzahl von Basisbereichen entspricht, das eine maximale Anzahl von Einträgen aufweist, nachdem es einer Präfixexpansion unterzogen wurde, als ein Zielfeld; und
Expandieren des neuen Basisbereichs unter Verwendung mindestens eines der Basisbereiche im Zielfeld, um nach der Expansion eine Mehrzahl von Bereichen zu erhalten.

4. Verfahren nach Anspruch 3, wobei das Expandieren des neuen Basisbereichs unter Verwendung des Basisbereichs im Zielfeld umfasst:
Durchqueren aller Basisbereiche im Zielfeld und Expandieren des neuen Basisbereichs unter Verwendung einer minimalen Anzahl von Basisbereichen, wobei eine Abdeckung der minimalen Anzahl von Basisbereichen den neuen Basisbereich nicht überschreitet.

5. Verfahren nach Anspruch 3 oder Anspruch 4, wobei das Expandieren des neuen Basisbereichs unter Verwendung mindestens eines der Basisbereiche im Zielfeld, um eine Mehrzahl von Bereichen nach der Expansion zu erhalten, umfasst:
nach dem Expandieren des neuen Basisbereichs unter Verwendung des mindestens einen Basisbereichs im Zielfeld, Bestimmen, ob der mindestens eine verwendete Basisbereich den neuen Basisbereich vollständig abdeckt;
als Reaktion auf ein Bestimmungsergebnis, dass der mindestens eine verwendete Basisbereich den neuen Basisbereich nicht vollständig abdecken kann, Erfassen eines Teilbereichs des neuen Basisbereichs, der durch den mindestens einen verwendeten Basisbereich nicht abgedeckt ist; und
Durchführen einer Präfixexpansion für den nicht abgedeckten Teilbereich, um einen Eintrag zu erhalten, der dem nicht abgedeckten Teilbereich entspricht.

6. Verfahren nach Anspruch 1 oder Anspruch 2, wobei das Durchführen einer Expansionsoperation an dem neuen Basisbereich basierend auf einer Mehrzahl von vorab gespeicherten Basisbereichen, um ein Expansionsergebnis zu erhalten, umfasst:
Erfassen einer Anzahl von Einträgen des neuen Basisbereichs, nachdem er der Expansionsoperation basierend auf der Mehrzahl von vorab gespeicherten Basisbereichen unterzogen wurde;
Vergleich der Anzahl der Einträge des neuen Basisbereichs, nachdem er der Expansionsoperation unterzogen wurde, mit der erfassten Anzahl der Einträge des neuen Basisbereichs, nachdem er der Präfixexpansion unterzogen wurde;
als Reaktion darauf, dass die Anzahl der Einträge des neuen Basisbereichs, nachdem er einer Präfixexpansion unterzogen wurde, geringer ist als die Anzahl der Einträge des neuen Basisbereichs, nachdem er der Expansionsoperation unterzogen wurde, Verwenden von Präfixinformationen, die aus der Präfixexpansion erhalten wurden, als Eingangsinformationen, die dem neuen Basisbereich entsprechen; oder als Reaktion darauf, dass die Anzahl der Einträge des neuen Basisbereichs, nachdem er einer Präfixexpansion unterzogen wurde, größer oder gleich der Anzahl der Einträge des neuen Basisbereichs ist, nachdem er der Expansionsoperation unterzogen wurde, Bestimmen von Eintraginformationen des neuen Basisbereichs basierend auf Eintraginformationen, die mehreren Komponenten des Expansionsergebnisses des neuen Basisbereichs entsprechen.

7. Verfahren nach Anspruch 1, wobei die codierten Informationen jedes der vorab gespeicherten Basisbereiche codierte Informationen umfassen, die den Feldinformationen entsprechen, und codierte Informationen, die den Bereichsinformationen entsprechen.

8. Anpassungsverfahren für Bereichsinformationen, umfassend:
Erfassen von Bereichsfeldinformationen, die in einem erhaltenen Paket (601) getragen werden;
Anpassen der Bereichsfeldinformationen an einen Basisbereich, der unter Verwendung des Verfahrens zum Codieren von Bereichsinformationen nach einem der Ansprüche 1 bis 7 erhalten wurde, um ein Anpassungsergebnis (602) zu erhalten; und
Verarbeiten des Pakets gemäß dem Anpassungsergebnis (603).

9. Computerlesbares Speichermedium, das ein Computerprogramm speichert, das, wenn es von einem Prozessor ausgeführt wird, den Prozessor veranlasst, das Verfahren zum Codieren von Bereichsinformationen nach einem der Ansprüche 1 bis 7 durchzuführen.

10. Codiervorrichtung für Bereichsinformationen, umfassend: einen Prozessor; und einen Speicher, der ein Computerprogramm speichert, das, wenn es von dem Prozessor ausgeführt wird, den Prozessor veranlasst, das Codierverfahren für Bereichsinformationen nach einem der Ansprüche 1 bis 7 durchzuführen.

11. Computerlesbares Speichermedium, das ein Computerprogramm speichert, das, wenn es von einem Prozessor ausgeführt wird, den Prozessor veranlasst, das Anpassungsverfahren für Bereichsinformationen nach Anspruch 8 durchzuführen.

12. Anpassungsvorrichtung für Bereichsinformationen, umfassend: einen Prozessor; und einen Speicher, der ein Computerprogramm speichert, das, wenn es von dem Prozessor ausgeführt wird, den Prozessor veranlasst, das Anpassungsverfahren für Bereichsinformationen nach Anspruch 8 durchzuführen.

## Revendications

1. Procédé de codage d'information de plage, comprenant :
l'acquisition d'une nouvelle plage de base, dans lequel la nouvelle plage de base est utilisée pour décomposer une information de plage d'une entrée à stocker dans une mémoire associative ternaire, TCAM (110) ;
**caractérisé en ce que** le procédé comprend en outre :
la réalisation d'une opération d'extension sur la nouvelle plage de base sur la base d'une pluralité de plages de base pré-stockées pour obtenir un résultat d'extension, dans lequel chacune des plages de base pré-stockées comporte une information codée respective (120) ; et
la détermination, conformément au résultat d'extension, d'une information codée qui correspond à la nouvelle plage de base (130).

2. Procédé selon la revendication 1, comprenant en outre, avant la réalisation d'une opération d'extension sur la nouvelle plage de base sur la base d'une pluralité de plages de base pré-stockées pour obtenir un résultat d'extension :
la détermination d'un nombre d'entrées de la nouvelle plage de base après qu'elle a été soumise à une extension de préfixe ;
dans lequel la réalisation d'une opération d'extension sur la nouvelle plage de base sur la base d'une pluralité de plages de base pré-stockées comprend :
en réponse au fait que le nombre d'entrées de la nouvelle plage de base après qu'elle a été soumise à une extension de préfixe n'est pas égal à 1, la réalisation de l'opération d'extension sur la nouvelle plage de base sur la base de la pluralité de plages de base pré-stockées.

3. Procédé selon la revendication 1 ou la revendication 2, dans lequel la réalisation d'une opération d'extension sur la nouvelle plage de base sur la base d'une pluralité de plages de base pré-stockées pour obtenir un résultat d'extension comprend :
en réponse au fait que chacune des plages de base pré-stockées comporte un champ correspondant respectif, la sélection du champ correspondant à l'une de la pluralité de plages de base, laquelle dispose d'un nombre maximum d'entrées après qu'elle a été soumise à une extension de préfixe, en tant que champ cible ; et
l'extension de la nouvelle plage de base en utilisant au moins l'une des plages de base dans le champ cible pour obtenir une pluralité de plages après l'extension.

4. Procédé selon la revendication 3, dans lequel l'extension de la nouvelle plage de base en utilisant la plage de base dans le champ cible comprend :
le parcours de toutes les plages de base dans le champ cible, et l'extension de la nouvelle plage de base en utilisant un nombre minimum de plages de base, dans lequel une couverture du nombre minimum de plages de base n'excède pas la nouvelle plage de base.

5. Procédé selon la revendication 3 ou la revendication 4, dans lequel l'extension de la nouvelle plage de base en utilisant au moins l'une des plages de base dans le champ cible pour obtenir une pluralité de plages après l'extension comprend :
après l'extension de la nouvelle plage de base en utilisant l'au moins une plage de base dans le champ cible, la détermination de si oui ou non l'au moins une plage de base utilisée couvre la nouvelle plage de base en totalité ;
en réponse à un résultat de détermination consistant en ce que l'au moins une plage de base utilisée ne peut pas couvrir la nouvelle plage de base en totalité, l'acquisition d'une sous-plage, non couverte par l'au moins une plage de base utilisée, de la nouvelle plage de base ; et
la mise en oeuvre d'une extension de préfixe sur la sous-plage non couverte pour obtenir une entrée correspondant à la sous-plage non couverte.

6. Procédé selon la revendication 1 ou la revendication 2, dans lequel la réalisation d'une opération d'extension sur la nouvelle plage de base sur la base d'une pluralité de plages de base pré-stockées pour obtenir un résultat d'extension comprend :
l'acquisition d'un nombre d'entrées de la nouvelle plage de base après qu'elle a été soumise à l'opération d'extension sur la base de la pluralité de plages de base pré-stockées ;
la comparaison du nombre d'entrées de la nouvelle plage de base après qu'elle a été soumise à l'opération d'extension avec le nombre d'entrées acquis de la nouvelle plage de base après qu'elle a été soumise à une extension de préfixe ;
en réponse au fait que le nombre d'entrées de la nouvelle plage de base après qu'elle a été soumise à une extension de préfixe est inférieur au nombre d'entrées de la nouvelle plage de base après qu'elle a été soumise à l'opération d'extension, l'utilisation d'une information de préfixe obtenue à partir de l'extension de préfixe en tant qu'information d'entrée correspondant à la nouvelle plage de base ; ou en réponse au fait que le nombre d'entrées de la nouvelle plage de base après qu'elle a été soumise à une extension de préfixe est supérieur ou égal au nombre d'entrées de la nouvelle plage de base après qu'elle a été soumise à l'opération d'extension, la détermination d'une information d'entrée de la nouvelle plage de base sur la base de l'information d'entrée correspondant à de multiples composantes du résultat d'extension de la nouvelle plage de base.

7. Procédé selon la revendication 1, dans lequel l'information codée de chacune des plages de base pré-stockées comprend une information codée correspondant à une information de champ et une information codée correspondant à une information de plage.

8. Procédé de mise en correspondance d'information de plage, comprenant :
l'acquisition d'une information de champ de plage portée dans un paquet obtenu (601) ;
la mise en correspondance de l'information de champ de plage avec une plage de base obtenue en utilisant le procédé de codage d'information de plage selon l'une quelconque des revendications 1 à 7 pour obtenir un résultat de mise en correspondance (602) ; et
le traitement du paquet conformément au résultat de mise en correspondance (603).

9. Support de stockage lisible par ordinateur stockant un programme informatique qui, lorsqu'il est exécuté par un processeur, a pour effet que le processeur réalise le procédé de codage d'information de plage selon l'une quelconque des revendications 1 à 7.

10. Dispositif de codage d'information de plage, comprenant : un processeur ; et une mémoire qui stocke un programme informatique qui, lorsqu'il est exécuté par le processeur, a pour effet que le processeur réalise le procédé de codage d'information de plage selon l'une quelconque des revendications 1 à 7.

11. Support de stockage lisible par ordinateur stockant un programme informatique qui, lorsqu'il est exécuté par un processeur, a pour effet que le processeur réalise le procédé de mise en correspondance d'information de plage selon la revendication 8.

12. Dispositif de mise en correspondance d'information de plage, comprenant : un processeur ; et une mémoire qui stocke un programme informatique qui, lorsqu'il est exécuté par le processeur, a pour effet que le processeur réalise le procédé de mise en correspondance d'information de plage selon la revendication 8.
